(19) Europäisches Patentamt
European Patent Office
Office européen des brevets

(11) **EP 0 914 495 B1**

(12) **EUROPÄISCHE PATENTSCHRIFT**

(45) Veröffentlichungstag und Bekanntmachung des Hinweises auf die Patenterteilung:
**18.12.2002 Patentblatt 2002/51**

(51) Int Cl.[7]: **C23C 14/34**, C23C 14/35, H01J 37/34

(21) Anmeldenummer: **97929076.4**

(22) Anmeldetag: **15.07.1997**

(86) Internationale Anmeldenummer:
**PCT/CH97/00268**

(87) Internationale Veröffentlichungsnummer:
**WO 98/003696 (29.01.1998 Gazette 1998/04)**

(54) **TARGETANORDNUNG MIT EINER KREISFÖRMIGEN PLATTE**

TARGET ARRANGEMENT WITH A CIRCULAR DISK

ENSEMBLE CIBLE AVEC UNE PLAQUE CIRCULAIRE

(84) Benannte Vertragsstaaten:
**CH DE GB IE IT LI LU NL SE**

(30) Priorität: **22.07.1996 CH 182496**

(43) Veröffentlichungstag der Anmeldung:
**12.05.1999 Patentblatt 1999/19**

(73) Patentinhaber: **Unaxis Balzers Aktiengesellschaft**
**9496 Balzers (LI)**

(72) Erfinder:
• **DAXINGER, Helmut**
**CH-7323 Wangs (CH)**

• **HAAG, Walter**
**CH-9472 Grabs (CH)**
• **KUEGLER, Eduard**
**A-6800 Feldkirch (AT)**

(74) Vertreter: **Troesch Scheidegger Werner AG**
**Patentanwälte**
**Postfach**
**8032 Zürich (CH)**

(56) Entgegenhaltungen:
**US-A- 4 204 936          US-A- 5 164 063**

• **PATENT ABSTRACTS OF JAPAN vol. 95, no. 2, 31.März 1995 & JP 06 306597 A (MITSUBISHI MATERIALS CORP), 1.November 1994,**

**Beschreibung**

Die vorliegende Erfindung betrifft eine Targetanordnung nach Anspruch 1, weiter eine Magnetronquelle nach dem Oberbegriff von Anspruch 17 und ein Verfahren zum Beschichten nach demjenigen von Anspruch 31.

Aus der EP-0 127 272 ist eine Magnetronquelle bekannt, bei der eine bezüglich einer Quellenachse symmetrisch aufgebaute Targetanordnung mit Hilfe einer Klemmanordnung rückseitig gegen eine Kühlplatte gepresst wird. Die Targetanordnung umfasst bezüglich der Zentralachse symmetrisch geneigte Balken, welche zu einem umlaufenden rechteckigen Balkenviereck ergänzt werden können. Die Balken weisen in einer Schnittebene, welche die Zentralachse umfasst, längs ausgedehnte periphere Einformungen auf, und zwar aussenseitig und innenseitig, in welche äussere Klemmbalken einerseits und innere Klemmleisten anderseits, die Balken verspannend und gegen die Kühlplatte pressend, eingreifen.

Nachteilig an dieser vorbekannten Targetanordnung ist es, dass diese, wenn als Rahmen ausgebildet, nach Absputtern der einen Sputterfläche nicht zum Absputtern der Rückfläche gedreht werden kann oder dass die vorgesehenen seitlichen Einformungen bzw. Klemmbalken und Klemmleisten ein solches Wenden einzelner Targetbalken nicht erlauben, ganz abgesehen davon, dass ein Festspannen aberodierter Zerstäubungsflächen gegen die Kühlplatte eine drastische Verringerung der im Targetanordnungs-Neuzustand erfolgenden Targetkühlung zur Folge hätte. Damit müsste Sputtern nach Wenden der Targetbalken mit drastisch veränderten Prozessparametern vorgenommen werden und dabei insbesondere die Sputterleistung stark reduziert werden.

Aus der DE-OS-30 09 836 ist es bekannt, das abzusputternde Targetmaterial dadurch besser zu nutzen, dass Targetsegmente nach ihrer Sputtererosion auf einem Kühlkörper neu orientiert werden. Dabei sind verschiedene Targetklemmanordnungen und ein Nachbearbeiten der Targetsegmente notwendig.

Aus der US-A-4 204 936 ist eine Targetanordnung mit einer kreisförmigen Platte bekannt, die entlang ihrem umlaufenden Rand eine Einformung hat. In den Figuren ist diese Einformung symmetrisch zu einer Ebene gezeichnet, die senkrecht zur Zentrumsachse der Platte verläuft. Die eine Seite der Platte ist aus zu sputterndem Material, die Plattenrückseite mit einer Schicht eutektischen Lotes versehen, oder es sind daran Nuten mit Indiumdrähten vorgesehen, welche im Betrieb schmelzen. Die Kühlung der Platte erfolgt grossflächig über Schmelze des eutektischen Lotes oder der Indiumdrähte.

Aus der US-A-5 164 063 ist eine Magnetronquelle bekannt, die einen Topf mit umlaufender Seitenwand aufweist und eine in der Basis gebildete Ringkammer, worin ein Magnetsystem vorgesehen ist. Sie weist weiter eine um die Ringkammer lösbare Klemmanordnung auf, für die Targetanordnung.

Die vorliegende Erfindung setzt sich zum Ziel, eine Targetanordnung zu schaffen, welche eine wesentliche Erhöhung des für das Sputtern genutzten Anteils zu zerstäubenden Materials ermöglicht, bei gleichzeitiger Sicherstellung einer hervorragenden Schichtdicken-Gleichmässigkeit auf einem zu beschichtenden, insbesondere planen kreisplattenförmigen Werkstück.

Aufgabe der Magnetronquellenentwicklung, die der erfindungsgemäss vorgeschlagenen Quelle zugrunde liegt, ist es, die Verbesserung der Sputtermaterialnutzung am erfindungsgemässen Target auch zu ermöglichen.

Dies wird durch Ausbildung der erfindungsgemässen Magnetronquelle gemäss dem Kennzeichen von Anspruch 17 erreicht.

Durch das vorgeschlagene erfindungsgemässe Beschichtungsverfahren obgenannter Art, das sich nach dem kennzeichnenden Teil von Anspruch 31 auszeichnet, wird eine besonders wirtschaftliche Seriebeschichtung der genannten Werkstücke möglich, sei dies der Serie mit einer einheitlichen Beschichtung, sei dies der Serie mit sequentiell vorgenommenen unterschiedlichen Beschichtungen.

Bevorzugte Ausführungsformen der erfindungsgemässen Targetanordnung, insbesondere zur weiteren Verbesserung der Sputtermaterialnutzung bei hervorragender Schichtdicken-Gleichmässigkeit am Werkstück, sind in den Ansprüchen 2 bis 16 spezifiziert.

Bevorzugte Ausführungsformen der Magnetronquelle, welche einerseits die gezielte Ausnutzung der durch die erfindungsgemässe Targetanordnungsausbildung gegebenen Möglichkeiten erlauben und weiter auch den Wirkungsgrad von abgesputtertem Material zu an einem Werkstück abgelegtem Material optimieren, sind in den abhängigen Ansprüchen 18 bis 30 spezifiziert.

Die erfindungsgemässe Targetanordnung, Magnetronquelle sowie das erfindungsgemässe Verfahren eignen sich insbesondere für die Beschichtung optischer Speicherplatten, wie von DVD, von Photo-CDs, vorzugsweise von CD-R oder von Phase-Change-Platten.

Die Erfindung mit ihrer grundsätzlichen Material-Wirkungsgraderhöhung eignet sich insbesondere für den Einsatz beim Sputterbeschichten mit teuren Materialien, wie mit Platin, Gold, Silber, Aluminium usw., kurz, von Materialien, bei denen der erwähnte Wirkungsgrad auch wirtschaftlich von grosser Bedeutung ist.

Die Erfindung wird anschliessend beispielsweise anhand von Figuren erläutert.

Es zeigen:

Fig. 1 schematisch, einen Längsschnitt durch eine erfindungsgemässe Magnetronquelle mit erfindungsgemässer Targetanordnung;

Fig. 2 wiederum schematisch und in Darstellung gemäss Fig. 1, eine weitere Ausführungsform eines erfindungsgemässen Targets mit entsprechender quellenseitiger Klemmvorrichtung;

Fig. 3 in Darstellung analog zu Fig. 2, eine weitere Ausführungsform einer erfindungsgemässen Targetanordnung und, quellenseitig, der entsprechenden Klemmvorrichtung;

Fig. 4 über der Radialausdehnung einer erfindungsgemässen Targetanordnung gemäss Fig. 1, das nach erfindungsgemässem Wechseleinsatz resultierende Erosionsprofil;

Fig. 5 eine weitere Ausführungsform einer erfindungsgemässen Targetanordnung im Querschnitt, optimiert gemäss den Resultaten, wie sie in Fig. 4 dargestellt sind;

Fig. 6 in Darstellung analog zu Fig. 5, eine weitere Ausführungsform einer erfindungsgemässen Targetanordnung;

Fig. 7 in Darstellung analog zu den Fig. 5 bzw. 6, die Ausführungsform der Targetanordnung, wie sie an der Quelle gemäss Fig. 1 eingesetzt ist;

Fig. 8 in Darstellung analog zu den Fig. 5 bis 7, eine weitere Ausführungsform der erfindungsgemässen Targetanordnung;

Fig. 9 Schichtdickenverteilung in Prozent in Funktion der Erosionstiefe des Targets.

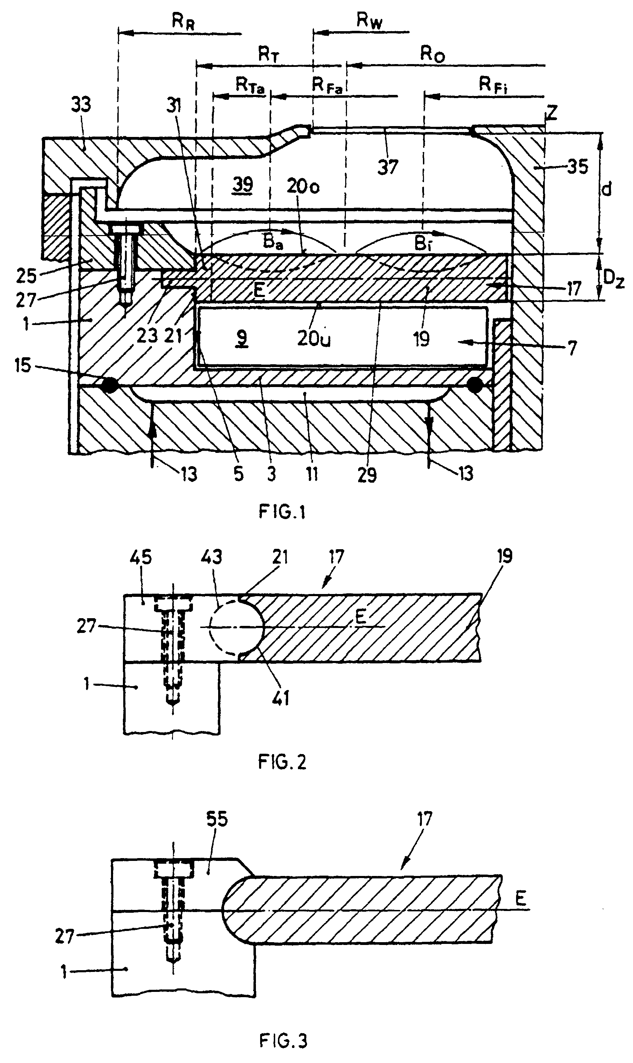

Gemäss Fig. 1, welche schematisch und im Längsschnitt die eine Hälfte einer erfindungsgemässen Magnetronanordnung mit montierter Targetanordnung darstellt, umfasst die Magnetronquelle einen Kühlkörper 1, welcher sowohl die Basis 3 wie auch die zylindrisch umlaufende Seitenwand 5 eines Aufnahmetopfes 7 mit dem Magnetronmagnetsystem 9 bildet. Der Kühlkörper 1 wird, wie dargestellt, mittels eines Kühlmedium-Zirkulationssystems 11 mit schematisch dargestellten Zu- und Wegleitungen 13 für das Kühlmedium gekühlt. In der dargestellten Ausführungsform liegt der Kühlkörper 1 direkt an dem im System 11 vorgesehenen Kühlmedium, wie Wasser, an. Hierzu sind schematisch dargestellte Dichtungen 15 vorgesehen. Das Kühlmedium-Zirkulationssystem kann aber auch durch eine wärmeleitende Zwischenmembran oder dünne Platte vom Kühlkörper 1 getrennt sein. Im weiteren kann sich das Kühlmedium-Zirkulationssystem auch in den Kühlkörper 1 erstrecken (nicht dargestellt), sei dies zusätzlich oder alternativ zu einem wie in Fig. 1 dargestellten System. Der Kühlkörper 1 ist aus gut wärmeleitendem Material, wie beispielsweise aus Kupfer, gefertigt.

Die erfindungsgemäss vorgesehene und selbst erfindungsgemässe Targetanordnung 17 weist eine Platte 19 auf, deren beide Plattenflächen 20o und 20u Flächen aus zu sputterndem Material sind. Entlang der um die kreisscheibenförmige Platte 19 umlaufenden zylindrischen Seitenfläche 21 erstreckt sich symmetrisch zu einer in der Seitenfläche 21 zentrierten radialen Ebene E bezüglich der Plattenzentrumsachse Z ein auskragender Flansch 23. Dieser ruht in einer entsprechenden Einformung im Kühlkörper 1 und ist durch einen Klemmring 25 mittels Spannbolzen 27 festgespannt. Zwischen der Seitenfläche 21 der Platte 19 und deren Flansch 23 einerseits und dem Kühlkörper 1 bzw. dem Klemmring 25 anderseits, ebenso wie zwischen Klemmring 25 und Kühlkörper 1, besteht bei eingespannter Platte 19 der Targetanordnung 17 ein enger Presskontakt, welcher optimalen Wärmeübergang zwischen den erwähnten Teilen 1, 25, 19 sicherstellt.

Auch im Klemmring 25 kann ein separater oder ein Teil des vorbeschriebenen Kühlmedium-Zirkulationssystems vorgesehen sein (nicht dargestellt).

Die Platte 19 ist in montiertem Zustand lediglich durch einen Spalt 29 vom darunterliegenden Magnetsystem 9 getrennt, oder es kann eine relativ dünne wärmeleitende und magnetisch permeable Abdeckplatte (nicht dargestellt) das Magnetsystem gegen die Targetanordnung 17 abschliessen, so dass der Spalt 29 zwischen letzterer und der unteren Fläche der Platte 19 gebildet wird. Jedenfalls berührt die untere Fläche 20u der Targetanordnung 17 darunterliegende Quellenteile nicht.

Durch die bis anhin beschriebene Quellen- und Targetanordnungskonstruktion wird erreicht, dass die Targetanordnung 17 durch Wärmeleitung über ihre Seitenfläche 21 und den Flansch 23 gekühlt wird, dass die Targetanordnung 17 nach Erreichen einer vorgegebenen Erosionstiefe an der einen Fläche 20 ohne weiteres gewendet werden kann, wobei durch Nichtberühren der jeweils unteren Fläche 20u sichergestellt bleibt, dass auch nach Wenden und Aberosion der einen Fläche die Kühlverhältnisse für die Targetanordnung praktisch gleich bleiben und bei einer wie in Fig. 1 dargestellten Platte 19 mit zur Ebene E symmetrische Flächen 20 alle Prozessparameter bei Weiterführung des Beschichtungsprozesses nach Wenden der Targetanordnung 17 unverändert beibehalten werden können.

Das Magnetsystem 9 erzeugt über der montierten Targetanordnung 17 zwei umlaufende Tunnelfeldmuster $B_a$ und $B_i$.

In einer bevorzugten Ausführungsform der Targetanordnung 17 beträgt der Radius $R_T$ der Platte 19:

$$85mm \leq R_T \leq 105mm.$$

Im weiteren beträgt bevorzugterweise der Radius $R_{Ta}$ zu zerstäubenden Materials;

$$75mm \leq R_{Ta} \leq 78mm.$$

Im weiteren beträgt bevorzugterweise die Gesamtdicke zu zerstäubenden Materials an der Platte 19, $D_z$, in der Ausführungsform gemäss Fig. 1, der Plattendicke entsprechend:

$$8mm \leq D_z \leq 14mm,$$

vorzugsweise

$$8mm \leq D_z \leq 10mm.$$

Bevorzugterweise besteht weiter das zu zerstäubende Material an der Platte 19 aus einem Metall, wie Aluminium oder Titan, bevorzugt aber aus relativ teuren Materialien, wie insbesondere aus Platin, Gold, Silber, wobei Gold besonders geeignet ist.

Bezüglich der mittleren Radien des äusseren umlaufenden ringförmigen Tunnelfeldes $B_a$, $R_{Fa}$ sowie des inneren kreisförmig umlaufenden Tunnelfeldes $B_i$, $R_{F1}$ gilt bevorzugterweise:

$$20mm \leq R_{Fi} \leq 30mm,$$

dabei vorzugsweise

$$24mm \leq R_{Fi} \leq 28mm$$

und/oder

$$55mm \leq R_{Fa} \leq 70mm.$$

Für den mittleren Radius des Bereiches zwischen den umlaufenden Tunnelfeldern B auf der Höhe der Fläche 20o, $R_o$, gilt vorzugsweise weiter:

$$35mm \leq R_o \leq 45mm.$$

Im weiteren beträgt die Feldkomponente der jeweiligen Tunnelfelder B parallel zur Zerstäubungsfläche 20o im Tunnelzentrum in einem Abstand von 10mm von der Fläche 20o höchstens 60%, vorzugsweise höchstens 55% dieser Komponente auf der Zerstäubungsfläche 20o, und es ist weiter bevorzugterweise diese Feldkomponente am inneren Tunnelfeld $B_i$ grösser als am äusseren $B_a$.

An der Fläche 20o beträgt, wiederum im Zentrum des Tunnelfeldes betrachtet, die Feldstärke mindestens 200G, dabei vorzugsweise 350G, dabei weiter bevorzugt am inneren Tunnelfeld $B_i$ mindestens 400G.

Wie aus Fig. 1 ersichtlich, wird mittels des Kühlkörpers 1 nebst der Targetanordnung 17 mit der Platte 19 auch das Magnetsystem 9 gekühlt.

Die Wärmeableitung von der Targetanordnung 17 erfolgt ausschliesslich über die Seitenfläche 21 mit dem Flansch 23, womit das Wenden der Targetanordnung dank der symmetrischen Einspannung ohne weiteres möglich ist.

In einer weiteren bevorzugten Ausführungsform wird, wie in Fig. 1 gestrichelt dargestellt, der Einspannbereich 31, d.h. der nicht gesputterte Randbereich, durch ein gut wärmeleitendes Material, wie z.B. aus Kupfer, gebildet.

Obwohl in Fig. 1 der Flansch plattenseitig angeordnet ist und die Aufnahmenut quellenseitig vorgesehen ist, ist es ohne weiteres möglich (nicht dargestellt), einen entsprechenden Flansch quellenseitig vorzusehen und eine Nut als Einnehmung plattenseitig.

Durch die Ausbildung der ineinandergreifenden Ein- und Ausnehmungen an der Seitenfläche 21, targetplatten- bzw. quellenseitig, wird die Wärmeleitung auf Grund der Vergrösserung der Kontaktflächen optimiert. Dadurch, und durch entsprechende Ausbildung des Einspannbereiches 31 wie erwähnt, wird auch das Verhältnis von Plattenausdehnung, $R_T$, zu Ausdehnung der genutzten Sputterfläche, $R_{Ta}$, optimiert.

Die erfindungsgemässe Quelle weist weiter einen Aussenmaskierring 33 auf sowie eine Innenmaske 35. Zwischen den Masken 33 und 35 liegt ein zu beschichtendes kreisscheibenförmiges Werkstück 37. Die Masken 33 und 35, die selbstverständlich auch mehrteilig ausgebildet sein können, übernehmen in bekannter Art Elektrodenfunktion für die Plasmaentladung des Sputterprozesses. Das Werkstück 37, die Plattenoberfläche 20o zusammen mit den Masken 33 und 35 bilden einen torusförmigen Prozessraum 39. Dabei ist vorzugsweise der maximale Radius $R_R$ des Torusraumes 39 grösser als der Radius $R_T$ der Platte 19. Bezeichnet d im weiteren den Abstand zwischen Zerstäubungsfläche 20o und zu beschichtender Fläche des Werkstückes 37. Vorzugsweise ist der Radius $R_R$ des Torusraumes 39 im Bereich von 20% bis 70% des Abstandes d grösser als der Radius $R_T$ der Targetplatte 19, vorzugsweise im Bereich von 20% bis 50% grösser.

Bezüglich der mittleren Radien der ringförmigen äusseren und inneren Tunnelfelder $R_{Fa}$ und $R_{Fi}$ gilt:

$$0,8 \leq (R_{Fa} - R_{Fi})/d \leq 3,0,$$

dabei bevorzugterweise

$$1,0 \leq (R_{Fa} - R_{Fi})/d \leq 2,2.$$

Bezüglich des Abstandes d gilt bevorzugterweise:

$$15mm \leq d \leq 30mm,$$

dabei bevorzugterweise

$$20mm \leq d \leq 25mm.$$

Der Radius $R_w$ des Werkstückes 37 ist dabei vorzugsweise höchstens 25% kleiner als der Radius $R_T$, vorzugsweise höchstens 20% kleiner, insbesondere aber höchstens 10% kleiner.

In Fig. 2 ist ausschnittsweise eine weitere Ausführungsform der Targecanordnung 17 mit Platte 19 und ihrer Befestigung am Kühlkörper 1 dargestellt.

Die Platte 19 weist entlang ihrer Seitenfläche 21 eine Einnehmung 41 bzw. Ausformung 43 auf, wie dargestellt bevorzugterweise im Querschnitt halbkreisförmig. Auf die Seitenfläche 21 aufgespannt ist ein Klemmring 45 mit entsprechender Ein- bzw. Ausformung vorgesehen. Der Klemmring kann nach Bedarf auch mehrteilig ausgebildet sein. Dieser ist mit Spannbolzen 27 am Kühlkörper 1 festgespannt. Bei Wenden der Targetanordnung, nun aus Platte 19 und Klemmring 45 bestehend, bleibt letzterer an der Platte 19 festgespannt. Diese Ausführungsform ermöglicht, wie bereits das Vorsehen des Einspannbereiches 31 gemäss Fig. 1, zu sputterndes Material nur in einem auch tatsächlich gesputterten Bereich der Targetanordnung 17 vorzusehen.

Mit dieser Massnahme kann eine Einsparung an zu sputterndem Material von ca. 25% erreicht werden, verglichen mit einer Ausbildung der Targetanordnung nach Fig. 1 mit bis nach aussen ($R_T$) vorgesehenem Sputtermaterial.

Bei einer Sputterleistung von 3kW wurde bei einem Kupfertarget der in Fig. 2 dargestellten Art mit einem Spannring 45 aus Kupfer bei den bevorzugten, oben angegebenen Dimensionen im Peripheriebereich des Targets beispielsweise eine Temperatur von 154°C gemessen, im Zentrum von 182°C.

Es ist bekannt, dass die Targetausnutzung pro mm Targetdicke üblicherweise mit zunehmender Targetdicke abnimmt, weil mit zunehmender Erosionstiefe der Erosionsgraben zunehmend eingeschnürt wird.

Auf Grund der erfindungsgemäss gegebenen Möglichkeit, die Targetanordnung zu wenden, ist es nun möglich, beidseitig das anfänglich breite Erosionsverhalten bis zur Targetmitte auszunutzen, was zu einer wesentlich besseren Targetmaterialnutzung führt.

Eine weitere Ausführungsform einer erfindungsgemässen Targetanordnung 17 mit Klemmring 55 und Kühlkörper 1 ist ohne weitere Erläuterungen aus Fig. 3 ersichtlich.

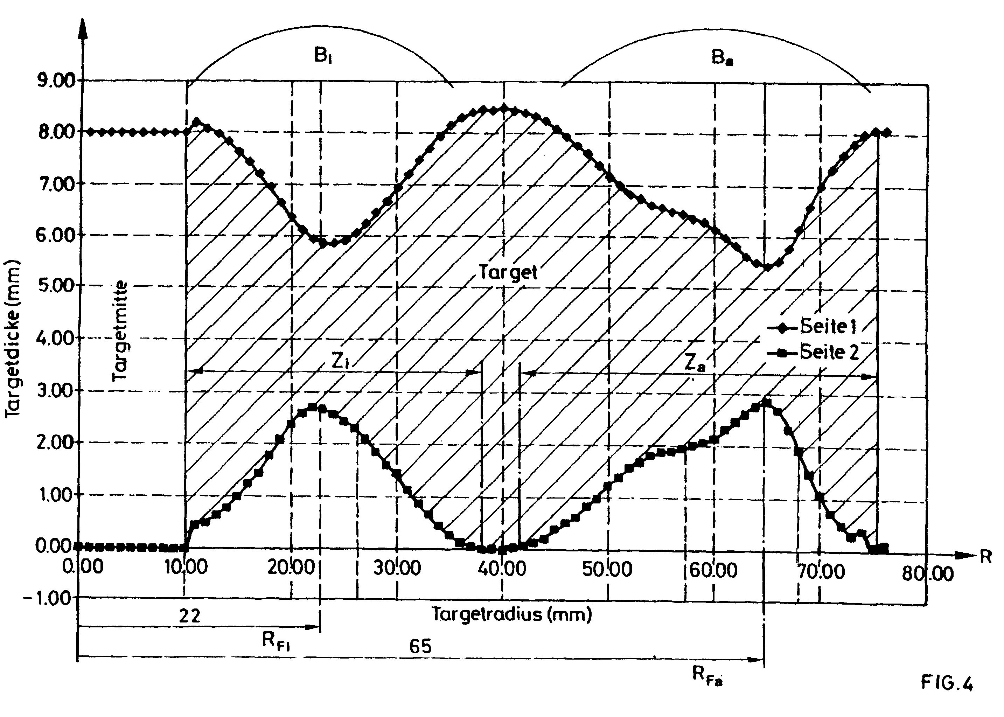

In Fig. 4 ist über dem Radius R eines Targets, wie beispielsweise in Fig. 1 dargestellt, das beidseitige Erosionsprofil abgetragen. Rein qualitativ sind dabei die vom Magnetsystem 9 erzeugten Tunnelfelder $B_i$, $B_a$, auf das Erosionsprofil abgestimmt, eingetragen.

Aus diesem Profil folgernd, lassen sich nun weitere Optimierungsmassnahmen im Sinne der vorliegenden Erfindung an der Targetanordnung ableiten, wie nachfolgend anhand der Fig. 6 bis 8 erläutert. Dabei besteht das Prinzip darin, zu sputterndes Material nur dort an der Targetanordnung vorzusehen, wo auch im wesentlichen abgesputtert wird, d.h. im wesentlichen in den Erosionsgrabenbereichen.

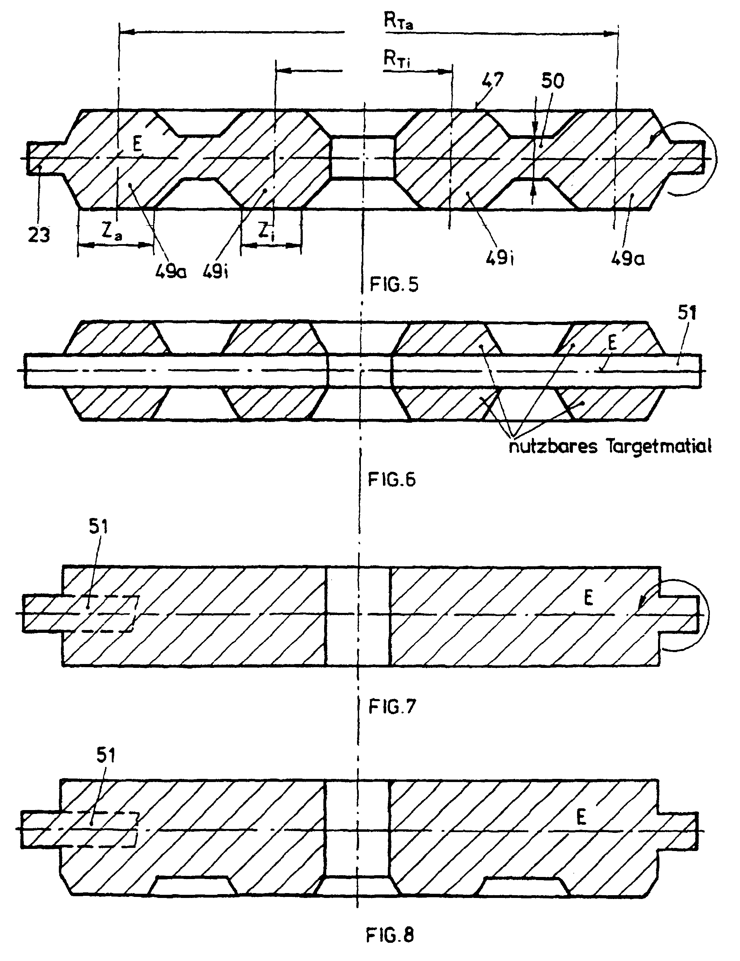

Gemäss Fig. 5 weist deshalb eine weitere bevorzugte Ausführungsform 47 einer Targetanordnung, symmetrisch zur Ebene E, einen inneren umlaufenden Wulst 49i und, davon getrennt durch einen vorzugsweise 1mm bis 4mm dicken Steg 50, weiter vorzugsweise 1,0 bis 2,5mm, einen äusseren umlaufenden Wulst 49a auf. Weil die Anordnung der Wulste 49i und 49a auf die Lage der Erosionsgräben gemäss Fig. 4 abgestimmt ist und letztere auf die Lage der Tunnelfelder $B_i$ bzw. $B_a$ an der Quelle gemäss Fig. 1, gilt für die mittleren Radien $\overline{R_{Ta}}$ und $\overline{R_{Ti}}$ der Wulste im wesentlichen:

$$\overline{R_{Ta}} \cong R_{Fa}$$

und

$$\overline{R_{Ti}} \cong R_{Fi},$$

womit die oben angegebenen bevorzugten Dimensionierungen für $R_F$ auch für die Wulste entsprechend $\overline{R_{Tx}}$ Gültigkeit haben. Für die Breite $Z_i$ des inneren Wulstes gilt bevorzugterweise:

$$20mm \leq Z_i \leq 35mm.$$

Für die Breite $Z_a$ des äusseren Wulstes gilt vorzugsweise:

$$28mm \leq Z_a \leq 40mm.$$

Die Dicke des Steges 50 beträgt vorzugsweise ca. 1,5mm, d.h., bezogen auf die Symmetrieebene E, ca. 0,75mm.

Während gemäss Fig. 5 die ganze Targetanordnung 47 einheitlich aus zu sputterndem Material besteht, ist bei der Ausführungsform gemäss Fig. 6 eine Bondplatte 51 aus nicht zu sputterndem Material vorgesehen, auf welcher nun aus zu sputterndem Material die inneren und äusseren Wulste aufgebaut sind.

In Fig. 7 ist eine Targetanordnung, wie an der Quelle gemäss Fig. 1 eingebaut, dargestellt, in Fig. 8 eine Targetanordnung, bei der nur einseitig Wulste vorgesehen sind, d.h. nur die eine Sputterfläche strukturiert ist. Selbstverständlich kann auch bei der Ausführungsform gemäss Fig. 7 eine Bondplatte bzw. eine Trägerplatte, wie gestrichelt bei 51 dargestellt, vorgesehen sein, ebenfalls bei der Ausführungsform gemäss Fig. 8. Insbesondere beim Aufbau der Targetanordnung mit einer Bondplatte 51 können die zu sputternden Plattenbereiche aus unterschiedlichen Materialien bestehen.

Für eine Werkstückserie wird bei Einbau einer Targetanordnung mit beidseits gleichen Sputtermaterialien an der Quelle gemäss Fig. 1 ein erster Teil der Werkstückserie mit der einen Sputterfläche der Targetanordnung beschichtet, ein zweiter Teil nach Wenden der Targetanordnung mit der zweiten Sputterflache.

Sind an der Targetanordnung oben und unten unterschiedliche Sputtermaterialien vorgesehen, so wird entweder der eine Teil der Serie mit dem einen Material beschichtet, dann die Targetanordnung gewendet und der zweite Teil der Serie mit dem zweiten Material, oder es wird die Serie erst mit dem einen und darnach mit dem zweiten Material beschichtet. Beispielsweise wird die eine Seite mit Gold, die andere mit Aluminium beschichtet. Diese Kombination wird insbesondere in der CD-R-Produktion gewählt, um die Masken 33, 35 mit Aluminium vorzubeschichten, damit später die Goldschicht von den Masken chemisch abgelöst werden kann.

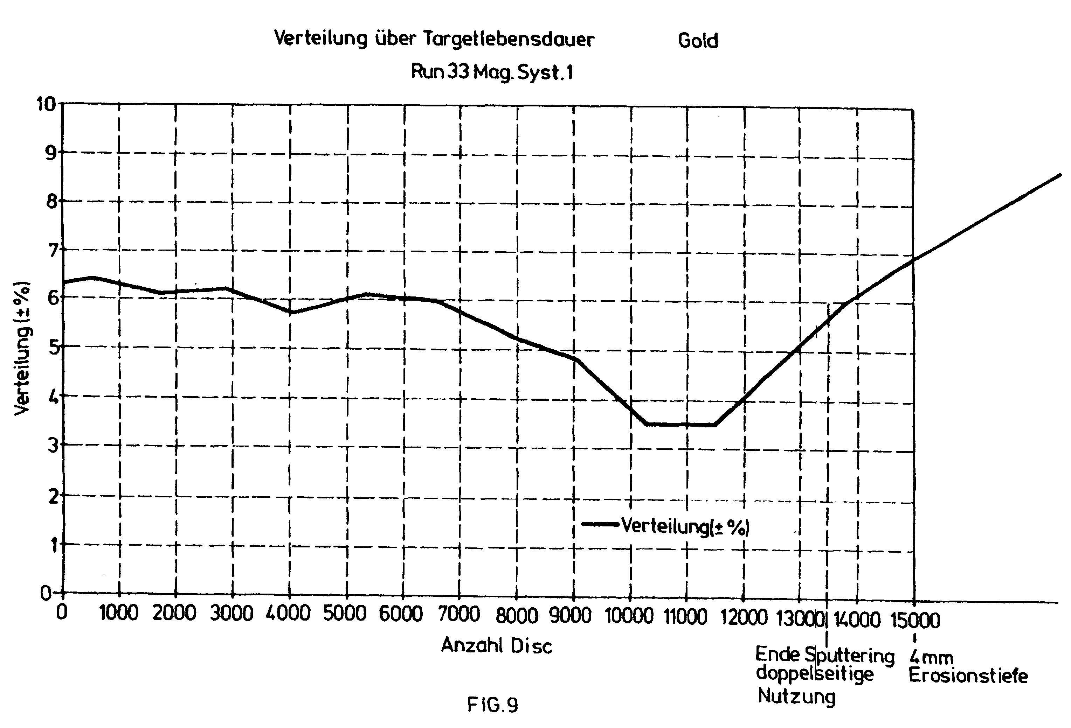

Fig. 9 zeigt die Abhängigkeit der Schichtdickenverteilung auf beschichteten Werkstücken mit zunehmender Erosion des Targets. Die Erosion wird durch die Zahl beschichteter Werkstücke dokumentiert.

Bei 15000 Stück wird eine Erosionstiefe von 4mm erreicht. Die Verteilung hat sich zu diesem Zeitpunkt bereits auf ±7% verschlechtert und wird noch schlechter, wenn man das Target noch länger benützt. Daher ist es notwendig, den Vorgang nach dem Beschichten von 13500 Werkstücken zu beenden.

Es wird deutlich, dass für eine grössere Anzahl zu beschichtender Werkstücke ein Target nicht einfach dicker gemacht werden und einseitig tiefer erodiert werden kann. Fig. 9 zeigt, dass ab Erosionstiefen von mehr als 4mm die Schichtdickenverteilung drastisch verschlechtert wird.

Ausserdem wird bei dickeren Targets auch der Grad der Materialausnutzung wesentlich schlechter wegen des Einschnürungseffekts beim Erosionsgraben. Erfindungsgemäss führt die beidseitige Nutzung des Targets somit neben reproduzierbaren Verteilungsverhältnissen auch zu einer wesentlich besseren Ausnutzung des Targetmaterials, was insbesondere bei teuren Materialien, wie Edelmetallen und insbesondere Gold, zu wirtschaftlich wesentlich besseren Ergebnissen führt.

Das folgende Beispiel zeigt den Unterschied einer 8mm Targetanordnung bei einseitiger bzw. doppelseitiger Nutzung.

a) Einseitige Targetausnutzung:

| Targetdurchmesser | $\Phi_A$ 152 / $\Phi_I$ 25mm |
|---|---|
| Targetdicke | 8mm |
| Targetgewicht neu | 1227g |
| Targetgewicht nach dem Sputtern | 957.8g |
| Targetausnutzung | 22% |

b) Beidseitige Targetausnutzung:

| Targetdurchmesser | $\Phi_A$ 152 / $\Phi_I$ 25mm |
|---|---|
| Targetdicke | 8mm |
| Targetgewicht neu | 1268g |
| Targetgewicht nach dem Sputtern | 868.5g |
| Targetausnutzung | 31.5% |

Das Ergebnis zeigt, dass eine Verbesserung um etwa 50% gegenüber der einseitigen Nutzung möglich ist, womit die Wirtschaftlichkeit drastisch erhöht wird.

Folgende Vorteile werden durch die vorliegende Erfindung erwirkt:

- Konstante Prozessparameter über die Targetlebensdauer.

- Rate, Sputterspannung und Schichtdickenverteilung variieren sehr viel weniger als bei einseitigem Targetsputtern, womit die sonst übliche Korrektur der Prozessparameter über die Targetlebensdauer entfällt.

- Die Schichteigenschaften bleiben konstant, was vor allem bei der CD-R-Produktion von Bedeutung ist, da hier äusserst empfindliche Substrate, wie Polycarbonat mit Dye beschichtet, verarbeitet werden.

- Die Targetausnützung wird wesentlich verbessert, da der extreme Plasmaeinschnüreffekt ab Erreichen der Targetmitte durch die Erosion vermieden wird. Es werden beidseits breite Erosionszonen ausgenützt.

- Die Partikelbildung wird verringert, womit sich eine verbesserte Prozessstabilität ergibt. Am Target gibt es nämlich immer sogenannte Rückbelegungszonen, d.h. Zonen, in denen Targetmaterial vermehrt aufwächst. Diese sind Zonen, an denen sich Sputtermaterialatome durch Streuung am Argonprozessgas ablagern. Mit zunehmender Targeteinsatzdauer werden diese abgelagerten Schichten dicker und neigen zum Abplatzen. Dies macht sich durch Kurzschlüsse und Arcing bemerkbar. Weil das erfindungsgemässe Vorgehen zur Halbierung der abgelagerten Schichtdicken führt, erhöht sich, wie erwähnt, die Prozessicherheit.

Durch Vorsehen einer gezielten Targetstrukturierung wird erreicht, dass nur dort unter Umständen teures Sputtermaterial vorgesehen ist, wo es auch nutzbringend verbraucht wird. Die symmetrische Targeteinspannung und die damit verbundene Kühlkontaktierung am Rand der Targetanordnung vereinfachen das Kühlsystem quellenseitig, reduzieren die Anzahl notwendiger Klemmelemente, indem jede Targetseite mit den gleichen Klemmelementen festgespannt werden kann. Der Wechsel der Targetanordnung ist äusserst einfach und schnell zu bewerkstelligen.

Das Vorgehen nach der vorliegenden Erfindung wendet sich ab von bisherigen Bestrebungen, durch Vergrösserung der Targetdicke eine längere Targetlebensdauer zu erreichen und damit längere Targetwechselintervalle. Nachteilig war dabei, dass immer stärkere und damit teurere Magnete eingesetzt werden mussten. Das Beschichtungsverhalten über die Targetlebensdauer war äusserst inhomogen, und die Targetausnutzung, zum Beispiel in g/kWh, sank drastisch mit zunehmender Targetdicke. Rückbelegungszonen wurden immer dicker und damit auch die Neigung zu Kurzschlüssen und zu Arcing. Ueblicherweise wurde auch ein Kühlkontakt zwischen Target und einem Kühlelement an der Targetrückseite erstellt. Alle Optimierungsbemühungen liefen darauf hinaus, diese Kontaktfläche zu vergrössern. Dabei standen diese Bestrebungen dem Aufbau und der Ausnützung symmetrisch wendbarer Targets im Wege.

## Patentansprüche

1. Targetanordnung mit einer kreisförmigen Platte (19), bei der entlang ihres umlaufenden Randes (21), symmetrisch zu einer Ebene (E) senkrecht zur Zentrumsachse der Platte (Z), mindestens eine Aus- und/oder Einformung (23; 41, 43) vorgesehen ist und bei der beide Plattenseiten (200, 20u) im wesentlichen durch Sputtermaterial und so gebildet sind, dass beide Plattenseiten Sputterneuflächen bilden.

2. Anordnung nach Anspruch 1, **dadurch gekennzeichnet, dass** die Ausformung als senkrecht zur Randfläche (21) auskragender Flansch (23) ausgebildet ist oder die Einformung als senkrecht zur Randfläche (21) eingearbeitete Nut.

3. Anordnung nach Anspruch 1, **dadurch gekennzeichnet, dass** die Ausformung oder Einformung im Querschnitt im wesentlichen halbkreisförmig ausgebildet ist, vorzugsweise mit einem Durchmesser, der im wesentlichen der Dicke der Platte (19) entspricht.

4. Anordnung nach einem der Ansprüche 1 bis 3, **dadurch gekennzeichnet, dass** mindestens der Randbereich (31) der Platte (19) mit der Ein- und/oder Ausformung (23) aus gut wärmeleitendem Material, vorzugsweise aus Kupfer, besteht.

5. Anordnung nach einem der Ansprüche 1 bis 4, **dadurch gekennzeichnet, dass** die Platte (19) umfasst:

   - eine obere durchgehende oder segmentierte bzw. profilierte Zerstäubungsplatte, eine Bondplatte und eine untere durchgehende oder segmentierte oder profilierte Zerstäubungsplatte aus dem selben oder aus unterschiedlichem Material wie die obere oder
   - eine einheitliche Zerstäubungsmaterialplatte.

6. Anordnung nach einem der Ansprüche 1 bis 5, **dadurch gekennzeichnet, dass** die Ebene (E) bezüglich der beiden Sputterflächen Symmetrieebene ist oder die beiden Sputterflächen unterschiedlich geformt sind.

7. Anordnung nach einem der Ansprüche 1 bis 6, **dadurch gekennzeichnet, dass** mindestens eine der Sputterflächen zwei durch eine umlaufende Rinne (50) getrennte Wulste (49i, 49a) aufweist.

8. Anordnung nach einem der Ansprüche 1 bis 7, **dadurch gekennzeichnet, dass** die Platte eine zentrumsöffnung aufweist.

9. Anordnung nach einem der Ansprüche 1 bis 8, **dadurch gekennzeichnet, dass** auf bzw. in eine Ein- bzw. Ausformung der Platte (19), formschlüssig eingreifend, ein umlaufender Klemmring (45) vorgesehen ist aus gut wärmeleitendem Material, wie vorzugsweise aus Kupfer, der die Ein- bzw. Ausformung der Anordnung bildet.

10. Anordnung nach Anspruch 7, **dadurch gekennzeichnet, dass** für die mittleren Radien ($\overline{R_{Ti}}$ und $\overline{R_{Ta}}$) der Wulste (49i, 49a) gilt:

$$14\text{mm} \leq \overline{R_{Ti}} \leq 30\text{mm},$$

dabei vorzugsweise

$$18\text{mm} \leq \overline{R_{Ti}} \leq 26\text{mm},$$

und/oder

$$55\text{mm} \leq \overline{R_{Ta}} \leq 70\text{mm}.$$

**11.** Anordnung nach Anspruch 7, **dadurch gekennzeichnet, dass** das Target im Wulstzwischenbereich 1mm bis 4mm dick ist, vorzugsweise 1,0mm bis 2,5mm.

**12.** Anordnung nach Anspruch 7, **dadurch gekennzeichnet, dass** der innere Wulst eine Breite $Z_i$ an seiner Aussenfläche aufweist, für die gilt:

$$20\text{mm} \leq Z_i \leq 35\text{mm},$$

und/oder eine Breite $Z_a$ des äusseren Wulstes an dessen Oberfläche, für die gilt:

$$28\text{mm} \leq Z_a \leq 40\text{mm}.$$

**13.** Anordnung nach einem der Ansprüche 1 bis 12, **dadurch gekennzeichnet, dass** für den Radius $R_T$ der Platte (19) gilt:

$$85\text{mm} \leq R_T \leq 105\text{mm}.$$

**14.** Anordnung nach einem der Ansprüche 1 bis 13, **dadurch gekennzeichnet, dass** für den Radius der Platte (19) mit Oberflächen aus Sputtermaterial, $R_{Ta}$, gilt:

$$75\text{mm} \leq R_{Ta} \leq 78\text{mm}.$$

**15.** Anordnung nach einem der Ansprüche 1 bis 14, **dadurch gekennzeichnet, dass** die Dicke des aus Sputtermaterial oder Trägerplatte und Sputtermaterial bestehenden Bereichs der Platte (19) höchstens 14mm beträgt, vorzugsweise zwischen 8mm und 10mm (beide Grenzen eingeschlossen).

**16.** Anordnung nach einem der Ansprüche 1 bis 15, **dadurch gekennzeichnet, dass** das Sputtermaterial ein Metall ist, wie Aluminium oder Titan, vorzugsweise ein Edelmetall, wie Platin, Gold, Silber, und weiter vorzugsweise Gold.

**17.** Magnetronquelle, umfassend:

- eine durch einen Topf mit umlaufender Seitenwand (5) und einer in der Basis (3) gebildeten Ringkammer (7), enthaltend ein Magnetsystem (9),

- eine lösbare Klemmanordnung (25) um die Ringkammer-Seitenwand (5) für die Targetanordnung (17),

**dadurch gekennzeichnet, dass**

- die lösbare Klemmanordnung (25) mindestens eine Ein- und/oder Ausformung hat, zur Aufnahme einer Targetanordnung nach einem der Ansprüche 1 - 16, wobei die Ein- und/oder Ausformung der Aus- und/oder Einformung an der Targetplatte entspricht,

- in den Topf ein Kühlmedium-Leitungssystem eingearbeitet ist, oder aber der Topf mit seiner Basis (3) auf einem Wärmesenkeblock mit einem Kühlmedium-Leitungssystem (11) aufgespannt ist,

- die Ringkammer (7) gegen die Klemmanordnung (25) hin offen ist oder durch eine dünne Metallplatte abgeschlossen ist, die keine aktiven Kühleinrichtungen aufweist.

**18.** Quelle nach Anspruch 17 mit eingebauter Targetanordnung, **dadurch gekennzeichnet, dass** die Unterseite (20u) der Targetplatte (19) bezüglich des Magnetsystems (9) beabstandet ist.

**19.** Quelle nach Anspruch 18, **dadurch gekennzeichnet, dass** die Klemmanordnung (25) die Targetanordnung (17) radial verspannt und weiter gegen die Topfwandung (1) spannt.

**20.** Quelle nach einem der Ansprüche 17 bis 19, **dadurch gekennzeichnet, dass** die Klemmanordnung einen umlaufenden Klemmring (25) umfasst, dessen Innenberandung radial die Targetanordnung einspannt und der gegen die Topfwandung (1) verspannt ist.

**21.** Quelle nach einem der Ansprüche 17 bis 20, **dadurch gekennzeichnet, dass** die Klemmanordnung ein Kühlmedium-Leitungssystem aufweist.

**22.** Quelle nach einem der Ansprüche 17 bis 21 mit eingespannter Targetanordnung, **dadurch gekennzeichnet, dass** das Magnetsystem über der Targetoberfläche zwei umlaufende tunnelförmige Feldmuster erzeugt, wobei für den mittleren Radius $R_{Fi}$ des inneren Feldtunnels und für den mittleren Radius $R_{Fa}$ des äusseren gilt:

$$20mm \leq R_{Fi} \leq 30mm,$$

dabei vorzugsweise

$$24mm \leq R_{Fi} \leq 28mm$$

und/oder

$$55mm \leq R_{Fa} \leq 70mm.$$

**23.** Quelle nach Anspruch 22, **dadurch gekennzeichnet, dass** für den mittleren Radius des Bereiches zwischen den Tunnelfeldern, $R_o$, gilt:

$$35mm \leq R_o \leq 45mm.$$

**24.** Quelle nach einem der Ansprüche 17 bis 23, **dadurch gekennzeichnet, dass** eine Halterung (33) für die Aufnahme eines kreisscheibenförmigen Werkstückes (37) koaxial zur Symmetrieachse (Z) der Quelle vorgesehen ist und dass weiter das Magnetsystem (9) über der eingespannten Targetanordnung (17) zwei umlaufende tunnelförmige Feldmuster erzeugt, wobei der innere Tunnelring einen mittleren Radius $R_{Fi}$ und der äussere einen mittleren Radius $R_{Fa}$ aufweist, und weiter zwischen einer Aufnahmeebene für das Werkstück (37) und der dem Werkstück zugewandten Oberfläche der Targetanordnung (17) der Abstand d ist und weiter gilt:

$$0,8 \leq (R_{Fa} - R_{Fi})/d \leq 3,0,$$

dabei vorzugsweise

$$1,0 \leq (R_{Fa} - R_{Fi})/d \leq 2,2.$$

**25.** Quelle nach einem der Ansprüche 17 bis 24, **dadurch gekennzeichnet, dass** das Magnetsystem (9) über der Targetanordnung zwei umlaufende ringförmige Tunnelfeldmuster ($B_a$, $B_i$) erzeugt und in 10mm Abstand von der Oberfläche der Targetanordnung die maximale horizontale Tunnelfeldkomponente höchstens 60%, vorzugsweise höchstens 55% dieser Komponente auf der Targetanordnungs-Oberfläche (20o) beträgt und diese Komponente vorzugsweise am inneren ringförmig umlaufenden Tunnelfeld ($B_i$) grösser ist als am äusseren ($B_a$).

26. Quelle nach einem der Ansprüche 17 bis 25, **dadurch gekennzeichnet, dass** das Magnetsystem (9) über der Targetoberfläche (200) zwei ringförmig umlaufende Tunnelfelder ($B_i$, $B_a$) erzeugt und dass die maximale in der Targetfläche (20o) liegende Feldkomponente mindestens 200G beträgt, vorzugsweise 350G, dabei insbesondere vorzugsweise im inneren Tunnelfeld ($B_i$) mindestens 400G.

27. Quelle nach Anspruch 24, **dadurch gekennzeichnet, dass** gilt:

$$15mm \leq d \leq 30mm,$$

dabei vorzugsweise

$$20mm \leq d \leq 25mm.$$

28. Quelle nach Anspruch 24, **dadurch gekennzeichnet, dass** die Halterung für eine Werkstückscheibe (37) ausgebildet ist, deren Radius ($R_W$) höchstens 25% kleiner ist als der Aussenradius ($R_T$) der Targetanordnungsplatte (19), vorzugsweise höchstens 20% kleiner ist, insbesondere aber höchstens 10% kleiner.

29. Quelle nach Anspruch 24, **dadurch gekennzeichnet, dass** ein an der Halterung (33) angeordnetes Werkstück (37) und die Sputteroberfläche (20o) der Targetanordnung (17) die obere bzw. untere Wandung eines torusförmigen Prozessraumes (39) definieren.

30. Quelle nach Anspruch 29, **dadurch gekennzeichnet, dass** der maximale Radius ($R_R$) des Torusraumes (39) grösser ist als der Aussenradius ($R_T$) der Sputterfläche (20o) der Targetanordnung (17), vorzugsweise um 20% bis 70% grösser ist als d, insbesondere bevorzugt um 20% bis 50% grösser als d.

31. Verfahren zum Beschichten einer Serie kreisscheibenförmiger Werkstücke mittels einer Magnetronquelle nach einem der Ansprüche 17 bis 30, **dadurch gekennzeichnet, dass**

   - ein erster Teil der Serie sputterbeschichtet wird,

   - die Targetanordnung an der Quelle gewendet wird und der zweite Teil der Serie beschichtet wird oder

   - die Serie sputterbeschichtet wird,

   - die Targetanordnung gewendet wird,

   - die Serie zum zweiten Mal beschichtet wird.

32. Verwendung der Targetanordnung nach einem der Ansprüche 1 bis 16 bzw. der Quelle nach einem der Ansprüche 17 bis 30 bzw. des Verfahrens nach Anspruch 31 zum Beschichten von optischen Speicherplatten, wie von DVD oder Photo-CDs, vorzugsweise von CD-R oder von Phase-Change-Platten.

**Claims**

1. Target arrangement with a circular plate (19), where along its peripheral edge (21) and symmetrical to a plane (E) vertical to the centre axis of the plate (Z) is provided at least one protrusion and/or recess (23; 41, 43) and where both plate sides (200, 20u) are essentially formed by sputtering material such that both plate sides form new sputtering surfaces.

2. Arrangement according to claim 1, **characterised in that** the protrusion is formed as a flange (23) protruding perpendicular to the edge surface (21) or the recess is formed as a groove recessed perpendicular to the edge surface (21).

3. Arrangement according to claim 1, **characterised in that** the protrusion or recess is formed essentially semicircular in cross-section, preferably with a diameter essentially corresponding to the thickness of the plate (19).

4. Arrangement according to any of claims 1 to 3, **characterised in that** at least the edge area (31) of the plate (19) with the recess and/or protrusion (23) consists of material with good heat conduction, preferably copper.

5. Arrangement according to any of claims 1 to 4, **characterised in that** the plate (19) comprises:

   - an upper complete or segmented or profiled sputtering plate, a bonding plate and a lower complete or segmented or profiled sputtering plate of the same as or a different material than the upper, or

   - a uniform sputtering material plate.

6. Arrangement according to any of claims 1 to 5, **characterised in that** the plane (E) is the plane of symmetry with respect to the two sputtering surfaces or the two sputtering surfaces are formed differently.

7. Arrangement according to any of claims 1 to 6, **characterised in that** at least one of the sputtering surfaces has two beads (49i, 49a) separated by a looped channel (50).

8. Arrangement according to any of claims 1 to 7, **characterised in that** the plate has a centre opening.

9. Arrangement according to any of claims 1 to 8, **characterised in that** on or in a protrusion or recess of the plate (19) and engaging by form fit there is provided a peripheral clamping ring (45) of material with good heat conduction such as preferably of copper, which forms the recess or protrusion of the arrangement.

10. Arrangement according to claim 7, **characterised in that** for the mean radii ($\overline{R_{Ti}}$ and $\overline{R_{Ta}}$) of the beads (49a, 49a) the following is true:

$$14 \text{ mm} \leq \overline{R_{Ti}} \leq 30 \text{ mm}$$

where preferably

$$18 \text{ mm} \leq \overline{R_{Ti}} \leq 26 \text{ mm}$$

and/or

$$55 \text{ mm} \leq \overline{R_{Ta}} \leq 70 \text{ mm}.$$

11. Arrangement according to claim 7, **characterised in that** the target in the area between the beads is 1 mm to 4 mm thick, preferably 1.0 mm to 2.5 mm.

12. Arrangement according to claim 7, **characterised in that** the inner bead has a width $Z_i$ on its outer surface for which the following is true:

$$20 \text{ mm} \leq Z_i \leq 35 \text{ mm},$$

and/or a width $Z_a$ of the outer bead at its surface for which the following is true:

$$28 \text{ mm} \leq Z_a \leq 40 \text{ mm}.$$

**13.** Arrangement according to any of claims 1 to 12, **characterised in that** for the radius $R_T$ of the plates (19) the following is true:

$$85 \text{ mm} \leq R_T \leq 105 \text{ mm}.$$

**14.** Arrangement according to any of claims 1 to 13, **characterised in that** for the radius $R_{Ta}$ of the plate (19) with the surfaces of sputtering material the following is true:

$$75 \text{ mm} \leq R_{Ta} \leq 78 \text{ mm}.$$

**15.** Arrangement according to any of claims 1 to 14, **characterised in that** the thickness of the area of the plate (19) consisting of sputtering material or carrier plate and sputtering material is maximum 14 mm, preferably between 8 mm and 10 mm (both limits included).

**16.** Arrangement according to any of claims 1 to 15, **characterised in that** the sputtering material is a metal such as aluminium or titanium, preferably a noble metal such as platinum, gold, silver, and further preferably gold.

**17.** Magnetron source comprising:

- a pot with peripheral side wall (5) and, formed in the base (3), a ring chamber (7) containing a magnet system (9),

- a releasable clamp arrangement (25) about the ring chamber side wall (5) for the target arrangement (17),

**characterised in that**

- the releasable clamp arrangement (25) has at least one recess and/or protrusion to hold a target arrangement according to any of claims 1 to 16, where the recess and/or protrusion corresponds to the protrusion and/or recess on the target plate,

- in the pot is embedded a coolant conduct system or the pot is clamped by its base (3) on a heat sink block with a coolant conduct system (11),

- the ring chamber (7) is open towards the clamp arrangement (25) or closed by a thin metal plate which has no active cooling facilities.

**18.** Source according to claim 17 with integral target arrangement, **characterised in that** the underside (20u) of the target plate (19) is spaced apart from the magnet system (9).

**19.** Source according to claim 18, **characterised in that** the clamp arrangement (25) grips the target arrangement (17) radially and furthermore biases it against the pot wall (1).

**20.** Source according to any of claims 17 to 19,
**characterised in that** the clamp arrangement has a looping clamping ring (25), the inner edge of which gripping the target arrangement radially and which is biased against the pot wall (1).

**21.** Source according to any of claims 17 to 20, **characterised in that** the clamp arrangement has a coolant conduct system.

**22.** Source according to any of claims 17 to 21 with clamped target arrangement, **characterised in that** over the target surface the magnet system generates two tunnel-like field pattern loops, where for the mean radius $R_{Fi}$ of the inner field tunnel and for the mean radius $R_{Fa}$ of the outer the following is true :

$$20 \text{ mm} \leq R_{Fi} \leq 30 \text{ mm},$$

thereby preferably

$$24 \text{ mm} \leq R_{Fi} \leq 28 \text{ mm},$$

and/or

$$55 \text{ mm} \leq R_{Fa} \leq 70 \text{ mm}.$$

**23.** Source according to claim 22, **characterised in that** for the mean radius of the area between the tunnel fields Ro the following is true:

$$35 \text{ mm} \leq R_o \leq 45 \text{ mm}.$$

**24.** Source according to any of claims 17 to 23, **characterised in that** a holder (33) is provided to hold a circular disc-like workpiece (37) co-axially to the axis of symmetry (Z) of the source and that further over the clamped target arrangement (17) the magnet system (9) generates two looping tunnel-like field patterns, where the inner tunnel ring has a mean radius $R_{Fi}$ and the outer a mean radius $R_{Fa}$, and furthermore the distance between a receiving plane for the workpiece (37) and the surface of the target arrangement (17) facing the workpiece is d and furthermore the following is true

$$0.8 \leq (R_{Fa} - R_{Fi})/d \leq 3.0,$$

thereby preferably

$$1.0 \leq (R_{Fa} - R_{Fi})/d \leq 2.2.$$

**25.** Source according to any of claims 17 to 24, **characterised in that** over the target arrangement the magnet system (9) generates two looping annular tunnel field patterns (Ba, Bi) and at 10 mm distance from the surface of the target arrangement the maximum horizontal tunnel field component amounts to maximum 60%, preferably maximum 55% of this component on the target arrangement surface (20o), and this component preferably on the inner annular circumferential tunnel field (Bi) is greater than on the outer (Ba).

**26.** Source according to any of claims 17 to 25, **characterised in that** over the target surface (200) the magnet system (9) generates two looping annular tunnel fields ($B_i$, $B_a$) and that the maximum field component lying in the target surface ($20_o$) amounts to at least 200G, preferably 350G, thereby, in particular preferably in the inner tunnel field ($B_i$), at least 400G.

**27.** Source according to claim 24, **characterised in that** the following is true:

$$15 \text{ mm} \leq d \leq 30 \text{ mm},$$

where preferably

$$20 \text{ mm} \leq d \leq 25 \text{ mm}.$$

**28.** Source according to claim 24, **characterised in that** the holder is designed for a workpiece disc (37) with radius ($R_W$) maximum 25% smaller than the outer radius ($R_T$) of the target arrangement plate (19), preferably maximum 20% smaller, in particular however maximum 10% smaller.

**29.** Source according to claim 24, **characterised in that** a workpiece (37) arranged on the holder (33) and the sputtering surface ($20_o$) of the target arrangement (17) define the upper and lower wall of a toroidal process chamber (39).

**30.** Source according to claim 29, **characterised in that** the maximum radius ($R_R$) of the toroidal chamber (39) is greater than the outer radius ($R_T$) of the sputtering surface ($20_o$) of the target arrangement (17), preferably 20% to 70% greater than d, in particular preferably 20% to 50% greater than d.

**31.** Process for coating a series of circular disc-shaped workpieces by means of a magnetron source according to any of claims 17 to 30, **characterised in that**

- a first part of the series is sputter-coated,

- the target arrangement at the source is turned over and the second part of the series is coated, or

- the series is sputter-coated,

- the target arrangement is turned over,

- the series is coated for a second time.

**32.** Use of the target arrangement according to any of claims 1 to 16, or of the source according to any of claims 17 to 30 or of the process according to claim 31 for coating optical storage discs e.g. DVD or photo CDs, preferably CD-R or phase-change discs.

**Revendications**

**1.** Ensemble cible avec une plaque circulaire (19), dans laquelle le long de son bord périphérique (21) et de manière symétrique à un plan (E) vertical par rapport à l'axe central de la plaque (Z) est prévue au moins une protubérance et/ou une empreinte (23 ; 41, 43) et dans laquelle les deux côtés de la plaque (20o, 20u) sont essentiellement formés par une matière pour pulvérisation cathodique de telle manière que les deux côtés de la plaque forment de nouvelles surfaces de pulvérisation cathodique.

**2.** Ensemble suivant la revendication 1, **caractérisé en ce que** la protubérance est formée comme une bride (23) dépassant perpendiculairement à la surface périphérique (21) ou **en ce que** l'empreinte est formée comme une rainure entaillée perpendiculairement à la surface périphérique (21).

**3.** Ensemble suivant la revendication 1, **caractérisé en ce que** la protubérance ou l'empreinte est formée essentiellement de manière semi-circulaire au niveau de la coupe transversale, de préférence avec un diamètre correspondant essentiellement à l'épaisseur de la plaque (19).

**4.** Ensemble suivant l'une quelconque des revendications 1 à 3, **caractérisé en ce que** au moins la zone périphérique (31) de la plaque (19) avec l'empreinte et/ou la protubérance (23) se compose d'une matière présentant une bonne conduction thermique, de préférence du cuivre.

**5.** Ensemble suivant l'une quelconque des revendications 1 à 4, **caractérisé en ce que** la plaque (19) comporte :

- une plaque de pulvérisation cathodique supérieure complète ou segmentée ou profilée, une plaque de bonding et une plaque de pulvérisation cathodique inférieure complète ou segmentée ou profilée de la même matière ou d'une matière différente de celle du haut ou,

- une plaque de matière de pulvérisation cathodique uniforme.

**6.** Ensemble suivant l'une quelconque des revendications 1 à 5, **caractérisé en ce que** le plan (E) est le plan de symétrie par rapport aux deux surfaces de pulvérisation cathodique ou **en ce que** les deux surfaces de pulvérisation cathodique sont formées différemment.

**7.** Ensemble suivant l'une quelconque des revendications 1 à 6, **caractérisé en ce que** au moins une des surfaces de pulvérisation cathodique a deux boudins (49i, 49a) séparées par une gorge formant boucle (50).

**8.** Ensemble suivant l'une quelconque des revendications 1 à 7, **caractérisé en ce que** la plaque comporte une ouverture centrale.

**9.** Ensemble suivant l'une quelconque des revendications 1 à 8, **caractérisé en ce que** sur ou dans une protubérance ou une empreinte de la plaque (19) et s'engageant par adaptation de forme se trouve une bague de serrage formant boucle (45) d'une matière présentant une bonne conduction thermique telle, de préférence, du cuivre, qui forme l'empreinte ou la protubérance de l'ensemble.

**10.** Ensemble suivant la revendication 7, **caractérisé en ce que**, pour les rayons moyens ($\overline{R_{Ti}}$ et $\overline{R_{Ta}}$) des boudins (49a, 49a), ce qui suit est vrai :

$$14 \text{ mm} \leq \overline{R_{Ti}} \leq 30 \text{ mm}$$

où de préférence

$$18 \text{ mm} \leq \overline{R_{Ti}} \leq 26 \text{ mm}$$

et/ou

$$55 \text{ mm} \leq \overline{R_{Ta}} \leq 70 \text{ mm}.$$

**11.** Ensemble suivant la revendication 7, **caractérisé en ce que** la cible dans la zone entre les boudins fait de 1 à 4 mm d'épaisseur, de préférence de 1 à 2,5 mm.

**12.** Ensemble suivant la revendication 7, **caractérisé en ce que** le boudin intérieure a une largeur $Z_i$ sur sa surface extérieure pour laquelle ce qui suit'est vrai :

$$20 \text{ mm} \leq Z_i \leq 35 \text{ mm},$$

et/ou une largeur $Z_a$ du boudin extérieure sur sa surface pour laquelle ce qui suit est vrai :

$$28 \text{ mm} \leq Z_a \leq 40 \text{ mm}.$$

**13.** Ensemble suivant l'une quelconque des revendications 1 à 12, **caractérisé en ce que**, pour le rayon RT des plaques (19), ce qui suit est vrai :

$$85 \text{ mm} \leq R_T \leq 105 \text{ mm}.$$

**14.** Ensemble suivant l'une quelconque des revendications 1 à 13, **caractérisé en ce que**, pour le rayon $R_{Ta}$ de la plaque (19) avec les surfaces de matière de pulvérisation cathodique, ce qui suit est vrai :

$$75 \text{ mm} \leq R_{Ta} \leq 78 \text{ mm}.$$

**15.** Ensemble suivant l'une quelconque des revendications 1 à 14, **caractérisé en ce que** l'épaisseur de la zone de la plaque (19) composée de matière de pulvérisation cathodique ou de la plaque porteuse et de la matière de pulvérisation cathodique fait au maximum 14 mm, de préférence entre 8 et 10 mm (les deux limites étant incluses).

**16.** Ensemble suivant l'une quelconque des revendications 1 à 15, **caractérisé en ce que** la matière de pulvérisation cathodique est un métal tel l'aluminium ou le titane, de préférence un métal noble tel le platine, l'or, l'argent, et de plus de préférence de l'or.

**17.** Source de magnétrons comportant :

- un pot avec paroi latérale périphérique (5) et formée dans la base (3) une chambre annulaire (7) contenant un système magnétique (9),

- un ensemble de serrage desservable (25) autour de la paroi latérale (5) de la chambre annulaire pour l'ensemble ciblé (17),

**caractérisée en ce que**

- l'ensemble de serrage desservable (25) a au moins une empreinte et/ou une protubérance pour tenir un ensemble cible suivant l'une quelconque des revendications 1 à 16, où l'empreinte et/ou la protubérance correspond à la protubérance et/ou l'empreinte sur la plaque cible,
- dans le pot se trouve encastré un système de conduit de milieu de refroidissement ou **en ce que** le pot est fixé par sa base (3) sur un bloc dissipateur de chaleur avec un système de conduits de milieu de refroidissement (11),
- la chambre annulaire (7) est ouverte vers l'ensemble de serrage (25) ou fermée par une plaque métallique mince qui ne comporte aucun dispositif actif de refroidissement.

**18.** Source suivant la revendication 17 avec ensemble cible intégré, **caractérisée en ce que** la partie inférieure (20u) de la plaque cible (19) est écartée du système magnétique (9).

**19.** Source suivant la revendication 18, **caractérisée en ce que** l'ensemble de serrage (25) saisit l'ensemble cible (17) de manière radiale et par ailleurs le bande contre la paroi du pot (1).

**20.** Source suivant l'une quelconque des revendications 17 à 19, **caractérisée en ce que** l'ensemble de serrage comporte un anneau de serrage périphérique (25), dont le bord intérieur saisit l'ensemble cible de manière radiale et qui est bandé contre la paroi du pot (1).

**21.** Source suivant l'une quelconque des revendications 17 à 20, **caractérisée en ce que** l'ensemble de serrage comporte un système de conduits de milieu de refroidissement.

**22.** Source suivant l'une quelconque des revendications 17 à 21 avec un ensemble cible fixé, **caractérisée en ce que** sur la surface cible le système magnétique génère deux configurations formant boucle de champ en forme de tunnel, où, pour le rayon moyen $R_{Fi}$ du tunnel de champ intérieur et pour le rayon moyen $R_{Fa}$ du tunnel de champ extérieur, ce qui suit est vrai :

$$20 \text{ mm} \leq R_{Fi} \leq 30 \text{ mm},$$

où de préférence

$$24 \text{ mm} \leq R_{Fi} \leq 28 \text{ mm},$$

et/ou

$$55 \text{ mm} \leq R_{Fa} \leq 70 \text{ mm}.$$

**23.** Source suivant la revendication 22, **caractérisée en ce que**, pour le rayon moyen de la zone entre les champs de tunnel $R_o$, ce qui suit est vrai :

$$35 \text{ mm} \leq R_o \leq 45 \text{ mm}.$$

**24.** Source suivant l'une quelconque des revendications 17 à 23, **caractérisée en ce qu'**un dispositif porteur (33) est prévu pour porter une pièce à travailler en forme de disque circulaire (37) de manière co-axiale à l'axe de symétrie (Z) de la source et **en ce que** par ailleurs sur l'ensemble cible fixé (17) le système magnétique (9) génère deux configurations de champ formant boucle en forme de tunnel, où l'anneau intérieur en forme de tunnel a un rayon moyen $R_{Fi}$ et l'anneau extérieur un rayon moyen $R_{Fa}$, et par ailleurs, la distance entre un plan récepteur pour la pièce à travailler (37) et la surface de l'ensemble cible (17) faisant face à la pièce à travailler est d et par ailleurs, ce qui suit est vrai

$$0.8 \le (R_{Fa} - R_{Fi})/d \le 3.0,$$

où de préférence

$$1.0 \le (R_{Fa} - R_{Fi})/d \le 2.2.$$

**25.** Source suivant l'une quelconque des revendications 17 à 24, **caractérisée en ce que** sur l'ensemble cible le système magnétique (9) génère deux configurations de champ formant boucle annulaire en forme de tunnel ($B_a$, $B_i$) et à 10 mm de distance de la surface de l'ensemble cible le composant de champ en forme de tunnel horizontal maximum représente au plus 60 %, de préférence au plus 55 % de ce composant sur la surface de l'ensemble cible ($20_o$), et ce composant de préférence sur le champ en forme de tunnel annulaire intérieur ($B_i$) est supérieur à celui de l'extérieur ($B_a$).

**26.** Source suivant l'une quelconque des revendications 17 à 25, **caractérisée en ce que** sur la surface cible ($20_o$) le système magnétique (9) génère deux champs formant boucle annulaire en forme de tunnel ($B_i$, $B_a$) et que le composant de champ maximum reposant sur la surface cible ($20_o$) représente au moins 200G, de préférence 350G, et en particulier, de préférence dans le champ intérieur en forme de tunnel ($B_i$), au moins 400G.

**27.** Source suivant la revendication 24, **caractérisée en ce que** ce qui suit est vrai:

$$15 \text{ mm} \le d \le 30 \text{ mm},$$

où de préférence

$$20 \text{ mm} \le d \le 25 \text{ mm}.$$

**28.** Source suivant la revendication 24, **caractérisée en ce que** le dispositif porteur est conçu pour un disque à travailler (37) avec un rayon ($R_W$) au maximum 25 % inférieur au rayon extérieur ($R_T$) de la plaque de l'ensemble cible (19), de préférence au maximum 20 % inférieur, en particulier toutefois au maximum 10 % inférieur.

**29.** Source suivant la revendication 24, **caractérisée en ce qu'**une pièce à travailler (37) disposée sur le dispositif porteur (33) et la surface de pulvérisation cathodique (20o) de l'ensemble cible (17) définissent les parois supérieure et inférieure d'une chambre de traitement toroïdale (39).

**30.** Source suivant la revendication 29, **caractérisée en ce que** le rayon maximum ($R_R$) de la chambre toroïdale (39) est supérieur au rayon extérieur ($R_T$) de la surface de pulvérisation cathodique (20o) de l'ensemble cible (17), de préférence de 20 à 70 % supérieur à d, en particulier de préférence 20 à 50 % supérieur à d.

**31.** Procédé pour recouvrir une série de pièces à travailler en forme de disque circulaire au moyen d'une source de magnétrons suivant l'une quelconque des revendications 17 à 30, **caractérisé en ce que**

- une première partie de la série est revêtue par une pulvérisation cathodique,

- l'ensemble cible de la source est tourné et la deuxième partie de la série est revêtue, ou

- la série est revêtue par une pulvérisation cathodique,

- l'ensemble cible est tourné,

- la série est revêtue une deuxième fois.

32. Utilisation de l'ensemble cible suivant l'une quelconque des revendications 1 à 16, ou de la source suivant l'une quelconque des revendications 17 à 30 ou du procédé suivant la revendication 31 pour revêtir des disques de mémoire optique, par exemple DVD ou CD photo, de préférence CD-R ou disques à changement de phase.

FIG.1

FIG.2

FIG.3

FIG.4

FIG.5

nutzbares Targetmatial

FIG.6

FIG.7

FIG.8

Verteilung über Targetlebensdauer     Gold

Run 33 Mag. Syst. 1

FIG.9